# EUROPÄISCHE PATENTSCHRIFT

(11) **EP 2 581 221 B1**
(45) Veröffentlichungstag und Bekanntmachung des Hinweises auf die Patenterteilung: **17.06.2015**
(21) Anmeldenummer: 12187747.6
(22) Anmeldetag: 09.10.2012
(51) Int. Cl.: B32B 17/10, B32B 27/08, B32B 27/32, B32B 27/34, H01L 31/042, H01L 31/048

(54) **Verwendung einer Mehrschichtfolie mit Polyamid- und Polypropylenschichten für die Herstellung photovoltaischer Module**
Use of a multilayered film comprising polyamide and polypropylene layers for the production of photovoltaic modules
Utilisation d'une feuille multicouche avec des couches de polypropylène et polyamide pour la fabrication de modules photovoltaïques

(30) Priorität: 14.10.2011 DE 102011084521
(43) Veröffentlichungstag der Anmeldung: 17.04.2013
(73) Patentinhaber: Evonik Industries AG, 45128 Essen (DE)
(72) Erfinder: Pawlik, Andreas, Dr., 45657 Recklinghausen (DE); Wielpütz, Martin, Dr., 48308 Senden (DE); Häger, Harald, Dr., 59348 Lüdinghausen (DE)

(56) Entgegenhaltungen:
- EP-A1- 2 422 976

## Beschreibung

Die Erfindung betrifft die Verwendung einer Mehrschichtfolie mit Polyamid- und Polypropylenschichten für die Herstellung von Solarmodulen.

Solarmodule, häufig auch als photovoltaische Module bezeichnet, dienen zur elektrischen Energieerzeugung aus Sonnenlicht und bestehen aus einem Laminat, welches als Kernschicht ein Solarzellensystem enthält. Diese Kernschicht ist mit Einkapselungsmaterialien umhüllt, die als Schutz gegen mechanische und witterungsbedingte Einflüsse dienen.

Die aktive Solarzelle befindet sich hierbei zwischen einer Frontabdeckung und einer Rückabdeckung. Die Frontabdeckung ist lichtdurchlässig und besteht im Regelfall aus Glas; sie ist mittels einer Haftvermittlerschicht, die häufig aus einem EthylenVinylacetat-Copolymeren besteht, mit der die Solarzelle enthaltenden Schicht verbunden. Die Rückabdeckung garantiert elektrische Abschirmung und dient als Schutz gegen Witterungseinflüsse, wie UV-Licht, und als Feuchtigkeitsbarriere.

Für die Rückabdeckung werden zur Zeit standardmäßig Folienverbunde aus Fluorpolymerfolien und Polyester verwendet. Die Fluorpolymerfolie an der Außenseite garantiert dabei die Witterungsbeständigkeit, die Polyesterfolie die mechanische Stabilität und die gewünschten elektrischen Isolationseigenschaften. Eine weitere Fluorpolymerfolie an der Innenseite dient zur Anbindung an die Siegelschicht des Solarzellensystems. Allerdings weisen derartige Fluorpolymerfolien nur eine geringe Haftung zur Siegelschicht auf, die als Einbettungsmaterial für die Solarzellen selbst verwendet wird. Darüber hinaus trägt die Fluorpolymerfolie nur in untergeordnetem Maß zur elektrischen Isolierung bei, woraus die Notwendigkeit der Verwendung einer vergleichsweise dicken Polyesterfolie resultiert.

In der WO 2008138022 wird daher vorgeschlagen, bei derartigen Verbunden die beiden Fluorpolymerfolien durch Folien aus Polyamid 12 (PA12) zu ersetzen. In einer Weiterbildung hiervon wird in der WO 2011066595 vorgeschlagen, dass die der Solarzelle zugewandte Thermoplastschicht einen Licht reflektierenden Füllstoff wie Titandioxid enthält, während die der Solarzelle abgewandte Thermoplastschicht einen zweiten Füllstoff, wie Glasfasern, Wollastonit oder Glimmer enthält, der eine höhere Wärmeleitfähigkeit dieser Schicht bewirkt. Beispielhafte Thermoplaste entstammen der Gruppe der Polyamide, Polyester oder Blends aus Polyamid und Polyolefin. Explizit genannt werden PA11, PA12 und PA1010 sowie deren Blends mit Polyolefinen.

Die Kombination von Polyamid- und Polypropylenschichten in einem solchen Verbund wäre wegen der sehr guten elektrischen Isolierungseigenschaften interessant. Allerdings wird bei einer derartigen Thermoplastkombination keine ausreichende Haftung der Schichten erreicht.

Die Aufgabe der Erfindung ist es, eine Mehrschichtfolie mit guter Schichtenhaftung zur Verfügung zu stellen, die als Rückfolie für ein Solarmodul eine gute elektrische Isolierung gewährleistet.

Diese Aufgabe wird gelöst durch die Verwendung einer Mehrschichtfolie als Rückabdeckung eines photovoltaischen Moduls, wobei die Mehrschichtfolie aus folgenden Schichten besteht:
a) Eine der Solarzelle zugewandte Schicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
c) eine Mittelschicht bestehend aus einer Formmasse, die einen Anteil an Polypropylen von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält, sowie
e) eine nach außen hin angeordnete Schicht aus einer Formmasse, die einen Polyamidanteil von mindestens 35 Gew.-%, bevorzugt mindestens 40 Gew.-%, besonders bevorzugt mindestens 45 Gew.-%, insbesondere bevorzugt mindestens 50 Gew.-% und ganz besonders bevorzugt mindestens 55 Gew.-%, jeweils bezogen auf die gesamte Formmasse, enthält,
und wobei eine Haftung zwischen den Schichten gemäß a) und c) sowie zwischen den Schichten gemäß c) und e) durch eine Maßnahme erzeugt wird, die ausgewählt ist aus
1. Anwesenheit von Polypropylen mit einer zur Haftungsverbesserung ausreichenden Konzentration von Säureanhydridgruppen in der Schicht gemäß c). Hierbei kann entweder das gesamte Polypropylen dieser Formmasse oder nur ein Teil hiervon funktionalisiert sein. Hinsichtlich des funktionalisierten Polypropylens gilt das Gleiche wie im nächsten Punkt. Alternativ hierzu kann die Polypropylenformmasse auch ein damit verträgliches funktionalisiertes Polyolefin enthalten, das ausreichend funktionelle Gruppen, insbesondere Säureanhydridgruppen oder Epoxidgruppen, zur Anbindung an die Polyamidschichten zur Verfügung stellt, wie beispielsweise Copolymerisate aus Ethylen, Methyl- und/oder Ethylacrylat sowie Glycidylmethacrylat bzw. Maleinsäureanhydrid (MSA). Dieses funktionalisierte Polyolefin ist mit dem Polypropylen verträglich, wenn es hiermit entweder molekular mischbar ist oder nach dem Compoundieren im Polypropylen thermodynamisch stabil dispergiert ist, so dass es eine ausreichend feste Phasenhaftung zu den Schichten gemäß a) und e) vermittelt.
2. Einbringen einer Haftvermittlerschicht b) zwischen den Schichten gemäß a) und c) und einer Haftvermittlerschicht d) zwischen den Schichten gemäß c) und e). Der Haftvermittler ist ein Polypropylen, das Säureanhydridgruppen enthält, die auf bekannte Weise durch thermische oder radikalische Reaktion des Polypropylens mit einem ungesättigten Dicarbonsäureanhydrid, einer ungesättigten Dicarbonsäure oder einem ungesättigten Dicarbonsäuremonoalkylester in einer Konzentration eingebracht werden, die für eine gute Anbindung an das Polyamid der benachbarten Schicht ausreicht. Geeignete Reagentien sind beispielsweise Maleinsäure, Maleinsäureanhydrid, Maleinsäuremonobutylester, Fumarsäure, Aconitsäure oder Itaconsäureanhydrid. Auf diese Weise sind vorzugsweise 0,1 bis 4 Gew.-% eines ungesättigten Anhydrids auf das Polypropylen aufgepfropft. Gemäß dem Stand der Technik kann das ungesättigte Dicarbonsäureanhydrid oder dessen Vorstufe auch zusammen mit einem weiteren ungesättigten Monomeren wie beispielsweise Styrol, α-Methylstyrol oder Inden aufgepfropft werden.

Das Polyamid kann ein teilkristallines Polyamid sein wie beispielsweise PA6, PA66, PA610, PA612, PA10, PA810, PA106, PA1010, PA11, PA1011, PA1012, PA1210; PA1212, PA814, PA1014, PA618, PA512, PA613, PA813, PA914, PA1015, PA11, PA12 oder ein teilaromatisches Polyamid, ein sogenanntes Polyphthalamid (PPA). (Die Kennzeichnung der Polyamide entspricht internationaler Norm, wobei die erste(n) Ziffer(n) die C-Atomzahl des Ausgangsdiamins und die letzte(n) Ziffer(n) die C-Atomzahl der Dicarbonsäure angeben. Wird nur eine Zahl genannt, so bedeutet dies, dass von einer α,ω-Aminocarbonsäure bzw. von dem davon abgeleiteten Lactam ausgegangen worden ist; im übrigen sei verwiesen auf H. Domininghaus, Die Kunststoffe und ihre Eigenschaften, Seiten 272 ff., VDI-Verlag, 1976.) Geeignete PPAs sind beispielsweise PA66/6T, PA6/6T, PA6T/MPMDT (MPMD steht für 2-Methylpentamethylendiamin), PA9T, PA10T, PA11T, PA12T, PA14T sowie Copolykondensate dieser letzten Typen mit einem aliphatischen Diamin und einer aliphatischen Dicarbonsäure oder mit einer ω-Aminocarbonsäure bzw. einem Lactam. Teilkristalline Polyamide besitzen eine Schmelzenthalpie von mehr als 25 J/g, gemessen mit der DSC-Methode gemäß ISO 11357 beim 2. Aufheizen und Integration des Schmelzpeaks.

Das Polyamid kann aber auch ein semikristallines Polyamid sein. Semikristalline Polyamide besitzen eine Schmelzenthalpie von 4 bis 25 J/g, gemessen mit der DSC-Methode gemäß ISO 11357 beim 2. Aufheizen und Integration des Schmelzpeaks. Beispiele für geeignete semikristalline Polyamide sind
- Das Polyamid aus 1,10-Decandisäure oder 1,12-Dodecandisäure und 4,4'-Diaminodicyclohexylmethan (PA PACM10 und PA PACM12), ausgehend von einem 4,4'-Diaminodicyclohexylmethan mit einem trans,trans-Isomerenanteil von 35 bis 65 %;
- Copolymere auf Basis der obengenannten teilkristallinen Polyamide; sowie
- Blends aus den obengenannten teilkristallinen Polyamiden und einem damit verträglichen amorphen Polyamid.

Das Polyamid kann auch ein amorphes Polyamid sein. Amorphe Polyamide besitzen eine Schmelzenthalpie von weniger als 4 J/g, gemessen mit der DSC-Methode gemäß ISO 11357 beim 2. Aufheizen und Integration des Schmelzpeaks. Beispiele für amorphe Polyamide sind:
- das Polyamid aus Terephthalsäure und/oder Isophthalsäure und dem Isomerengemisch aus 2.2.4- und 2.4.4-Trimethylhexamethylendiamin,
- das Polyamid aus Isophthalsäure und 1.6-Hexamethylendiamin,
- das Copolyamid aus einem Gemisch aus Terephthalsäure/Isophthalsäure und 1.6-Hexamethylendiamin, gegebenenfalls in Mischung mit 4.4'-Diaminodi-cyclohexylmethan,
- das Copolyamid aus Terephthalsäure und/oder Isophthalsäure, 3.3'-Dimethyl-4.4'-diaminodicyclohexylmethan und Laurinlactam oder Caprolactam,
- das (Co)Polyamid aus 1.12-Dodecandisäure oder Sebacinsäure, 3.3'-Dimethyl-4.4'-diaminodicyclohexylmethan und gegebenenfalls Laurinlactam oder Caprolactam,
- das Copolyamid aus Isophthalsäure, 4.4'-Diaminodicyclohexylmethan und Laurinlactam oder Caprolactam,
- das Polyamid aus 1.12-Dodecandisäure und 4.4'-Diaminodicyclohexylmethan (bei niedrigem trans,trans-Isomerenanteil),
- das (Co)Polyamid aus Terephthalsäure und/oder Isophthalsäure sowie einem alkylsubstituierten Bis(4-aminocyclohexyl)methan-Homologen, gegebenenfalls in Mischung mit Hexamethylendiamin,
- das Copolyamid aus Bis(4-amino-3-methyl-5-ethyl-cyclohexyl)methan, gegebenenfalls zusammen mit einem weiteren Diamin, sowie Isophthalsäure, gegebenenfalls zusammen mit einer weiteren Dicarbonsäure,
- das Copolyamid aus einer Mischung von m-Xylylendiamin und einem weiteren Diamin, z. B. Hexamethylendiamin, sowie Isophthalsäure, gegebenenfalls zusammen mit einer weiteren Dicarbonsäure wie z. B. Terephthalsäure und/oder 2,6-Naphthalindicarbonsäure,
- das Copolyamid aus einer Mischung von Bis(4-amino-cyclohexyl)methan und Bis-(4-amino-3-methyl-cyclohexyl)methan sowie aliphatischen Dicarbonsäuren mit 8 bis 14 C-Atomen, sowie
- Polyamide oder Copolyamide aus einer Mischung, die 1.14-Tetradecandisäure sowie ein aromatisches, arylaliphatisches oder cycloaliphatisches Diamin enthält.

Diese Beispiele können durch Hinzunahme weiterer Komponenten (z. B. Caprolactam, Laurinlactam oder Diamin/Dicarbonsäure-Kombinationen) oder durch teilweisen oder vollständigen Ersatz von Ausgangskomponenten durch andere Komponenten weitestgehend variiert werden.

Das Polyamid kann auch ein Polyetheresteramid oder ein Polyetheramid sein. Polyetheresteramide sind z. B. aus der DE-A-25 23 991 und der DE-A-27 12 987 bekannt; sie enthalten als Comonomer ein Polyetherdiol. Polyetheramide sind beispielsweise aus der DE-A- 30 06 961 bekannt; sie enthalten als Comonomer ein Polyetherdiamin.

Beim Polyetherdiol bzw. dem Polyetherdiamin kann die Polyethereinheit beispielsweise auf 1.2-Ethandiol, 1.2-Propandiol, 1.3-Propandiol, 1.4-Butandiol oder 1.3-Butandiol basieren. Die Polyethereinheit kann auch gemischt aufgebaut sein, etwa mit statistischer oder blockweiser Verteilung der von den Diolen herrührenden Einheiten. Das Gewichtsmittel der Molmasse der Polyetherdiole bzw. Polyetherdiamine liegt bei 200 bis 5000 g/mol und vorzugsweise bei 400 bis 3000 g/mol; ihr Anteil am Polyetheresteramid bzw. Polyetheramid beträgt bevorzugt 4 bis 60 Gew.-% und besonders bevorzugt 10 bis 50 Gew.-%. Geeignete Polyetherdiamine sind durch Konversion der entsprechenden Polyetherdiole durch reduktive Aminierung oder Kupplung an Acrylnitril mit nachfolgender Hydrierung zugänglich; sie sind z. B. in Form der JEFFAMIN^{®} D- oder ED-Typen oder der ELASTAMINE^{®}-Typen bei der Huntsman Corp. oder in Form der Polyetheramin D-Reihe bei der BASF SE kommerziell erhältlich. In geringeren Mengen kann auch ein Polyethertriamin mit verwendet werden, z. B. ein JEFFAMIN^{®} T-Typ, falls ein verzweigtes Polyetheramid eingesetzt werden soll. Vorzugsweise setzt man Polyetherdiamine bzw. Polyethertriamine ein, die pro Ethersauerstoffatom im Mittel mindestens 2,3 Kohlenstoffatome in der Kette enthalten. Erfindungsgemäß sind Polyetheramide wegen der besseren Hydrolysebeständigkeit bevorzugt.

Das Polypropylen kann grundsätzlich jeder handelsübliche Polypropylentyp sein, beispielsweise isotaktisches oder syndiotaktisches Homopolypropylen, ein Randomcopolymer von Propen mit Ethen und/oder Buten-1, ein Propen-Ethen-Blockcopolymer und dergleichen. Das Polypropylen kann nach jedem bekannten Verfahren hergestellt werden, beispielsweise nach Ziegler-Natta oder mittels Metallocenkatalyse. Es kann eine Schlagzähkomponente wie z. B. EPM- oder EPDM-Kautschuk oder SEBS enthalten. Vorzugsweise ist das Polypropylen ein sogenanntes Propen-Ethen-Blockcopolymer, häufig auch als Heterophasen-Copolymer bezeichnet. Derartige Heterophasen-Copolymere können beispielsweise in einem zweiphasigen Prozess hergestellt werden, der in etwa wie folgt abläuft: Zuerst wird, z. B. mit einem Ziegler-Natta-Katalysator, ein hoch isotaktisches Polypropylen hergestellt, wobei unter Umständen eine kleine Menge Ethen anwesend sein kann, was ein Random-Copolymerisat ergibt. Dieses Material fungiert als Matrix eines Heterophasen-Copolymers. In einem zweiten Reaktionsschritt (gegebenenfalls in einem anderen Reaktor) wird gegebenenfalls ein zweiter Katalysator eingebracht, z. B. ein Metallocenkatalysator. Nun erfolgt eine Copolymerisation von Ethen mit Propen, wobei sich diese Polymerisation in Hohlräumen des ersten Polymerisats abspielt. Dadurch wird das zweite Polymerisat dort eingelagert. Das Blockcopolymer bzw. Heterophasen-Copolymer enthält in einer bevorzugten Ausführungsform mindestens 0,5 Gew.-%, mindestens 0,6 Gew.-%, mindestens 0,7 Gew.-%, mindestens 0,8 Gew.-% oder mindestens 0,9 Gew.-% sowie maximal 20 Gew.-%, maximal 15 Gew.-%, maximal 12 Gew.-%, maximal 10 Gew.-% oder maximal 8 Gew.-% an Ethen einpolymerisiert. Darüber hinaus können bis zu 15 Gew.-% 1-Buten einpolymerisiert sein.

Die Formmasse der Schicht gemäß a) kann entweder eines der obengenannten Polyamide oder mehrere als Gemisch enthalten. Weiterhin können bis zu 40 Gew.-%, bezogen auf den gesamten Polymeranteil der Formmasse, andere Thermoplaste enthalten sein, beispielsweise schlagzähmachende Kautschuke oder Polyolefine wie Polyethylen oder Polypropylen. Eventuell enthaltene Kautschuke oder Polyolefine enthalten vorzugsweise, dem Stand der Technik entsprechend, funktionelle Gruppen, mit denen eine Verträglichkeit mit der Polyamidmatrix erhalten wird. Darüber hinaus können die für Polyamide üblichen Hilfs- und Zusatzstoffe enthalten sein, insbesondere Licht- und/oder Wärmestabilisatoren, oder bevorzugt auch Licht reflektierende Füllstoffe wie beispielsweise Titandioxid (WO 2011066595).

Die Formmasse der Schicht gemäß c) kann die für Polypropylen üblichen Hilfs- und Zusatzstoffe enthalten, insbesondere Licht- und/oder Wärmestabilisatoren, Licht reflektierende Füllstoffe wie beispielsweise Titandioxid sowie verstärkende Füllstoffe wie beispielsweise Glasfasern, Wollastonit oder Glimmer.

Für die Formmasse der Schicht gemäß e) gilt das Gleiche wie für die Formmasse der Schicht gemäß a) sowie hinsichtlich Füllstoffen das Gleiche wie für die Formmasse der Schicht gemäß c). Zusätzlich kann die Formmasse der Schicht gemäß e) eingefärbt sein und/oder ein Mattierungsmittel aufweisen.

Die einzelnen Folienschichten weisen in der Regel folgende Dicken auf:
- Schichten gemäß a) und e): 15 bis100 µm und vorzugsweise 25 bis 50 µm;
- Schicht gemäß c): 100 bis 500 µm und vorzugsweise 150 bis 400 µm;
- Schichten gemäß b) und d): 3 bis 40 µm und vorzugsweise 5 bis 25 µm.

Die erfindungsgemäß verwendete Mehrschichtfolie kann nach allen Methoden des Standes der Technik hergestellt werden, beispielsweise durch Coextrusion oder Laminieren. Sie wird mit der Siegelschicht, in die die Solarzelle eingebettet ist, beispielsweise durch Laminieren oder Kleben verbunden. Wegen des Polyamidanteils in der Schicht gemäß a) wird beim Laminieren eine gute Haftung zur Siegelschicht erhalten. Als Siegelschicht kann jedes gemäß dem Stand der Technik gebräuchliche Material verwendet werden.

Gegenstand der Erfindung ist auch ein photovoltaisches Modul, das unter Verwendung der anspruchsgemäßen Mehrschichtfolie als Rückabdeckung hergestellt wurde.

Die Erfindung wird nachfolgend beispielhaft erläutert. Hierzu wurden folgende Formmassen hergestellt; bei "Teilen" handelt es sich immer um Gewichtsteile.

### Compound 1 für Außenschichten:

79,25 Teile VESTAMID^{®} L1901 nf (PA12), 0,5 Teile IRGANOX^{®} 1098 (ein sterisch gehindertes phenolisches Antioxidans), 0,2 Teile TINUVIN^{®} 312 (UV-Absorber) und 20 Teile des Titandioxids Sachtleben R 420 wurden mit Hilfe eines Zweiwellenextruders (Coperion Werner & Pfleiderer ZSK 25 WLE, 36 L/D) bei einer Zylindertemperatur von 220 °C gemischt. Der Strang wurde mit Hilfe eines Wasserbads gekühlt und geschnitten; das Granulat wurde anschließend 12 Stunden bei 80 °C im Umluftofen getrocknet.

### Compound 2 für Mittelschicht:

79,6 Teile Hostalen^{®} EPD60R (Propylen-Ethylen-Blockcopolymer), 20 Teile Kaolin TEC 110 und 0,4 Teile IRGANOX^{®} 1010 (sterisch gehindertes phenolisches Antioxidans) wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Compound 3 für Mittelschicht:

75,6 Teile Hostalen^{®} EPD60R, 4 Teile LOTADER^{®} AX 8900 (Terpolymer aus Ethylen, Methylacrylat und Glycidylmethacrylat), 20 Teile Kaolin TEC 110 und 0,4 Teile IRGANOX^{®} 1010 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Compound 4 für Mittelschicht:

43,6 Teile VESTAMID^{®} L1901, 32 Teile Hostalen^{®} EPD60%, 4 Teile LOTADER^{®} AX 8900, 20 Teile Kaolin TEC 110 und 0,4 Teile IRGANOX^{®} 1010 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Compound 5 für Haftvermittlerschicht:

95,6 Teile Hostalen^{®} EPD60R, 4 Teile LOTADER^{®} AX 8900 und 0,4 Teile IRGANOX^{®} 1010 wurden mit Hilfe eines Zweiwellenextruders (Coperion Werner & Pfleiderer ZSK 25 WLE, 36 L/D) bei einer Zylindertemperatur von 200 °C gemischt. Der Strang wurde mit Hilfe eines Wasserbads gekühlt und geschnitten; das Granulat wurde anschließend 12 Stunden bei 80 °C im Umluftofen getrocknet.

### Extrusion mehrschichtiger Folien:

Mit einer Mehrschichtfolienanlage der Fa. Collin (Breitschlitzdüse 300 mm, Spalt 0 - 6 mm, Co-Extrusionsfeedblock für 3-schichtige bzw. 5-schichtige Folien) wurden drei - und fünfschichtige Folien hergestellt (Verarbeitungstemperatur für Mittelschicht sowie Haftvermittlerschichten ca. 210 °C, für Außenschichten ca. 230 °C). Die Schichtdickenverteilung wurde wie folgt eingestellt:

| | |
|---|---|
| a / c / e: | 50 µm / 250µm / 50 µm |
| a / b / c / d / e2: | 50 µm / 10 µm / 230 µm / 10 µm / 50 µm |

Die Ergebnisse sind in der Tabelle 1 dargestellt.

**Tabelle 1: Beispiele**

| | Schichtaufbau | Durchschlag (KV) |
|---|---|---|
| Beispiel 1 | Compound 1/Compound 3/Compound 1 | 24 |
| Beispiel 2 | Compound 1/Compound 5/Compound 2/Compound 5/Compound 1 | 25 |
| Vergleichsbeispiel 1 | Compound 1/Compound 4/Compound 1 | 20 |

## Patentansprüche

1. Verwendung einer Mehrschichtfolie als Rückabdeckung eines photovoltaischen Moduls, wobei die Mehrschichtfolie aus folgenden Schichten besteht:
a) Eine der Solarzelle zugewandte Schicht aus einer Formmasse, die einen Polyamidanteil von mindestens 35 Gew.-%, bezogen auf die gesamte Formmasse, enthält,
c) eine Mittelschicht bestehend aus einer Formmasse, die einen Anteil an Polypropylen von mindestens 35 Gew.-%, bezogen auf die gesamte Formmasse, enthält, sowie
e) eine nach außen hin angeordnete Schicht aus einer Formmasse, die einen Polyamidanteil von mindestens 35 Gew.-%, bezogen auf die gesamte Formmasse, enthält,
wobei die Haftung zwischen den Schichten gemäß a) und c) sowie zwischen den Schichten gemäß c) und e) durch eine Maßnahme erzeugt wird, die ausgewählt ist aus
1. Anwesenheit von Polypropylen mit einer zur Haftungsverbesserung ausreichenden Konzentration von Säureanhydridgruppen oder eines mit Polypropylen verträglichen funktionalisierten Polyolefins, das ausreichend funktionelle Gruppen zur Anbindung an die Polyamidschichten zur Verfügung stellt, in der Formmasse der Schicht gemäß c) und
2. Einbringen einer Haftvermittlerschicht b) zwischen den Schichten gemäß a) und c) und einer Haftvermittlerschicht d) zwischen den Schichten gemäß c) und e), die aus einem Polypropylen bestehen, das Säureanhydridgruppen enthält, die durch thermische oder radikalische Reaktion des Poylpropylens mit einem ungesättigten Dicarbonsäureanhydrid, einer ungesättigten Dicarbonsäure oder einem ungesättigten Dicarbonsäuremonoalkylester eingebracht wurden.

2. Verwendung gemäß Anspruch 1,
**dadurch gekennzeichnet, dass**
• die Schichten gemäß a) und e) eine Dicke von 15 bis100 µm,
• die Schicht gemäß c) eine Dicke von 100 bis 500 µm und
• die Schichten gemäß b) und d) eine Dicke von 3 bis 40 µm besitzen.

3. Photovoltaisches Modul, erhalten unter Verwendung einer Mehrschichtfolie gemäß einem der vorhergehenden Ansprüche als Rückabdeckung.

## Claims

1. Use of a multilayer film as a back cover of a photovoltaic module, said multilayer film consisting of the following layers:
a) a solar cell-facing layer of a moulding composition comprising a polyamide content of at least 35% by weight, based on the overall moulding composition,
c) a middle layer consisting of a moulding composition comprising a proportion of polypropylene of at least 35% by weight, based on the overall moulding composition, and
e) an outer layer of a moulding composition comprising a polyamide content of at least 35% by weight, based on the overall moulding composition,
wherein the adhesion between the layers according to a) and c) and between the layers according to c) and e) is produced by a measure selected from
1. presence of polypropylene having a concentration of acid anhydride groups which is sufficient to promote adhesion, or of a polypropylene-compatible functionalized polyolefin that provides functional groups sufficiently for attachment to the polyamide layers, in the moulding composition of the layer according to c), and
2. introduction of an adhesion promoter layer b) between the layers according to a) and c) and of an adhesion promoter layer d) between the layers according to c) and e), said adhesion promoter layers consisting of a polypropylene which contains acid anhydride groups which have been introduced by thermal or free-radical reaction of the polypropylene with an unsaturated dicarboxylic anhydride, an unsaturated dicarboxylic acid or an unsaturated dicarboxylic acid monoalkyl ester.

2. Use according to Claim 1,
**characterized in that**
• the layers according to a) and e) have a thickness of 15 to 100 µm,
• the layer according to c) a thickness of 100 to 500 µm and
• the layers according to b) and d) a thickness of 3 to 40 µm.

3. Photovoltaic module obtained using a multilayer film according to either of the preceding claims as a back cover.

## Revendications

1. Utilisation d'une feuille multicouche comme recouvrement arrière d'un module photovoltaïque, la feuille multicouche étant constituée des couches suivantes :
a) une couche orientée vers la cellule solaire, constituée par une masse de moulage qui contient une proportion de polyamide d'au moins 35% en poids, par rapport à la masse de moulage totale,
c) une couche centrale constituée par une masse de moulage qui contient une proportion de polypropylène d'au moins 35% en poids, par rapport à la masse de moulage totale, ainsi que
e) une couche disposée vers l'extérieur, constituée par une masse de moulage qui contient une proportion de polyamide d'au moins 35% en poids, par rapport à la masse de moulage totale,
l'adhérence entre les couches a) et c) ainsi qu'entre les couches selon c) et e) étant obtenue par une mesure qui est choisie parmi
1. la présence de polypropylène présentant une concentration, suffisante pour améliorer l'adhérence, en groupes anhydride d'acide ou en une polyoléfine fonctionnalisée, compatible avec le propylène, qui met suffisamment de groupes fonctionnels à disposition pour la liaison aux couches de polyamide, dans la masse de moulage de la couche selon c) et
2. introduction d'une couche de promoteur d'adhérence b) entre les couches selon a) et c) et d'une couche de promoteur d'adhérence d) entre les couches selon c) et e), qui sont constituées d'un polypropylène qui contient des groupes anhydride d'acide, qui sont introduits par réaction thermique ou radicalaire du polypropylène avec un anhydride d'acide dicarboxylique insaturé, un acide dicarboxylique insaturé ou un ester monoalkylique d'un acide dicarboxylique insaturé.

2. Utilisation selon la revendication 1, **caractérisée en ce que**
- les couches selon a) et e) présentent une épaisseur de 15 à 100 µm,
- la couche selon c) présente une épaisseur de 100 à 500 µm et
- les couches selon b) et d) présentent une épaisseur de 3 à 40 µm.

3. Module photovoltaïque, obtenu par l'utilisation d'une feuille multicouche selon l'une quelconque des revendications précédentes comme recouvrement arrière.
